# FASCICULE DE BREVET EUROPEEN

(11) **EP 0 586 301 B1**
(45) Date de publication et mention de la délivrance du brevet: **19.03.1997**
(21) Numéro de dépôt: 93402132.0
(22) Date de dépôt: 01.09.1993
(51) Int. Cl.: C23C 16/02, C23C 16/04, C23C 16/44, H01L 21/285

(54) **Procédé de prétraitement de l'enceinte de dépôt et/ou du substrat pour le dépôt sélectif de tungstène**
Verfahren zur Vorbehandlung der Reaktionskammer und/oder des Substrates für die Selektive Auftragung des Wolframs
Process for the pretreatment of the reaction chamber and/or the substrate for the selective deposition of tungsten

(30) Priorité: 04.09.1992 FR 9210573
(43) Date de publication de la demande: 09.03.1994
(73) Titulaire: FRANCE TELECOM, 75015 Paris (FR)
(72) Inventeur: Rivoire, Maurice, F-38240 Meylan (FR)
(74) Mandataire: Orès, Bernard

(56) Documents cités:
- EP-A- 0 418 592
- EP-A- 0 430 303
- LE VIDE LES COUCHES MINCES vol. 42, no. 236 , 1987 , PARIS/FR pages 229 - 232 Kwakman L F T et al 'In-situ plasma etching as a tool for reproducible tungsten CVD'
- PROC. 6TH INTERNATIONAL IEEE VLSI MULTILEVEL INTERCONNECTION CONFERENCE 12 Juin 1989 , SANTA CLARA/USA pages 151 - 157 YAMAZAKI ET AL. 'Selective CVD Tungsten Contact Plug Technology with Plasma Pre-treatment'

## Description

L'Invention est relative à un procédé permettant d'améliorer le dépôt sélectif de tungstène(WF₆ réduit par SiH₄).

Le dépôt sélectif de tungstène en phase vapeur chimique (C.V.D.) est utilisé pour assurer l'interconnexion des couches métalliques lors de la fabrication des circuits électroniques. Le principe en est le suivant : le substrat à traiter comporte une couche conductrice, qui est soit une couche métallique (tungstène, aluminium, titane ou leurs dérivés), soit une couche de silicium, recouverte d'une couche d'oxyde de silicium dans laquelle sont ménagés, aux emplacements souhaités, des trous la traversant de part en part. Ces trous sont destinés à être remplis de tungstène, ce qui permet ainsi d'assurer la connexion entre des couches conductrices de part et d'autre de la couche d'oxyde de silicium.

On sait que des températures élevées de dépôt (comprises entre 330 et 400°C) améliorent considérablement les performances du dépôt de tungstène en permettant en particulier d'accroître l'adhérence (aucun décollement, résistance de contact diminuée), de diminuer la contrainte (inférieure au Giga-Pascal) et la résistivité du tungstène déposé.

Toutefois, le principal problème posé par le dépôt sélectif du tungstène, et en particulier à des températures élevées, concerne la sélectivité effective du dépôt. En effet, idéalement, le tungstène devrait se déposer uniquement à l'intérieur des trous ménagés dans l'oxyde de silicium, au contact du métal apparaissant au fond de ces trous et non sur la couche d'oxyde de silicium elle-même. En pratique, ce résultat est très difficile à obtenir, et ce problème de perte de selectivité est d'autant plus important que la température de dépôt est plus élevée. On considére généralement qu'il est impossible de procéder au dépôt sélectif de tungstène en phase vapeur à des températures supérieures à 300°C ; par exemple, K.Y.AHN et al. [Tungsten and other refractory metals for VLSI, Application IV MRS (1989)] ont étudié la croissance du dépôt de tungstène sélectif, et ont montré la perte de sélectivité à des températures supérieures à 300°C.

Il serait donc particulièrement souhaitable de parvenir à mettre au point un procédé permettant le dépôt de tungstène à températures élevées sans qu'il en résulte une perte de sélectivité.

Différentes équipes ont étudié les facteurs conditionnant le dépôt du tungstène sur l'oxyde de silicium, et les effets de divers traitements sur ce dépôt.

Il est connu (cf par exemple Demande EP 0430 303 au nom de APPLIED MATERIALS INC) de procéder préalablement au dépôt de tungstène, à un prétraitement de nettoyage afin de décaper le substrat, et d'éliminer l'humidité et les couches superficielles d'oxydes qui interfèrent avec le dépôt de tungstène ; la nature de ce traitement dépend de celle de la surface sur laquelle on souhaite par la suite déposer sélectivement le tungstène. Par exemple, selon la Demande EP 0430 303, on choisira de préférence, pour l'aluminium et les oxydes d'aluminium un traitement par un gaz halogéné tel que le BCl₃, pour le silicium et ses oxydes, un traitement par le NF₃ ou le SF₆, et pour le tungstène un traitement par l'hydrogène. Le prétraitement est effectué dans une chambre de nettoyage, et le substrat est ensuite transféré dans une chambre de dépôt, en vue du dépôt sélectif du tungstène.

La demande EP 418592 au nom de APPLIED MATERIALS INC décrit un procédé de prétraitement de la chambre de dépôt préalablement au dépôt sélectif de tungstène sur un substrat. Ce procédé inclut un premier traitement par le fluor, qui est suivi de l'induction d'un plasma d'hydrogène dans la chambre de dépôt afin d'éliminer les traces de fluor résiduels, et d'éviter que ces résidus de fluor interfèrent ensuite avec le dépôt de tungstène.

KAJIYANA et al. [Mat. Res. Soc. Symp. Proc. VLSIV, p. 39 (1990)] décrivent l'effet d'un prétraitement par un plasma de CF₄ + CHF₃ suivi d'un traitement par NF₃, sur le dépôt de tungstène sur un substrat de silicium. Le but de ce traitement est d'éviter la formation d'une couche irrégulière d'oxyde de silicium à la surface du substrat, car la présence de cette couche produit par la suite des irrégularités dans le dépôt du tungstène. Le traitement au plasma de CF₄ + CHF₃ a pour effet d'implanter une couche d'atomes de carbone en surface du silicium. Ces atomes de carbone sont ensuite eux-mêmes éliminés par balayage de la surface avec un plasma de NF₃. La qualité de la couche de tungstène déposée sur un substrat traité de la sorte a été déterminée par comparaison avec un substrat portant une couche d'oxyde de silicium natif, et un substrat prétraité par trempage dans une solution d'acide fluorhydrique. Ceci a permis de montrer que l'élimination de la couche d'oxyde, suivie d'un traitement par le NF₃ permet d'abaisser les températures de dépôt du tungstène ; le film formé à 280°C est similaire, de par son homogénéité et sa régularité, à celui obtenu lorsque l'on dépose le tungstène à 300°C après traitement du substrat par trempage dans l'acide fluorhydrique. Le prétraitement décrit par KAJIYANA et al. a donc pour effet, non pas d'augmenter la sélectivité du dépôt à température élevée, mais d'améliorer les caractéristiques du dépot effectué à basse température.

TAMARU et al. [Dry Process Symposium, Electrochemical Society, Pennington N.J. (1990)] ont étudié l'effet de différents traitements de surface sur la sélectivité du dépôt de tungstène en phase vapeur sur la surface du tungstène apparaissant au fond de trous ménagés dans une couche d'oxyde de silicium. Il ressort de cette étude que c'est le prétraitement au BCl₃ qui permet d'améliorer le plus efficacement la sélectivité du dépôt de tungstène. Selon ces auteurs, ce traitement génère des liaisons Si-Cl ainsi que des molécules de SiClₓ et de SiClₓO_{y}, qui demeurent pendant un temps suffisant en surface de la couche d'oxyde de silicium pour la protéger contre l'attaque par des molécules d'hexafluorure de tungstène lors du dépôt de tungstène par CVD. Ces mêmes auteurs indiquent également qu'un traitement au NF₃ ne permet pas d'obtenir une sélectivité comparable, ce qui serait dû au fait que les liaisons Si-F n'assurent qu'une faible protection de l'oxyde de silicium contre l'attaque par le WF₆.

Or l'Inventeur a maintenant mis au point un procédé permettant d'améliorer la sélectivité du dépôt de tungstène en phase vapeur et d'obtenir une excellente sélectivité à des températures de dépôt supérieures à 300°C.

L'Inventeur a en effet constaté qu'un prétraitement de la chambre de dépôt par un plasma d'un gaz fluoré de façon à laisser subsister des traces de fluor résiduel dans ladite chambre de dépôt, préalablement au dépôt sélectif du tungstène, améliorait considérablement la sélectivité dudit dépôt.

La présente Invention concerne l'utilisation du fluor résiduel subsistant dans une chambre de dépôt et/ou sur un substrat après traitement de ladite chambre et/ou dudit substrat par un plasma d'un gaz fluoré, pour améliorer la sélectivité du dépôt de tungstène en phase vapeur sur ledit substrat dans ladite chambre de dépôt.

La présente Invention a pour objet un procédé de dépôt sélectif de tungstène sur un substrat constitué de tungstène et d'oxyde de silicium, caractérisé en ce que l'on effectue un prétraitement par le fluor de la chambre de dépôt en induisant dans ladite chambre de dépôt un plasma de gaz fluoré, optionnellement associé à un gaz diluant inerte, et en ce que l'on effectue le dépôt de tungstène en phase vapeur sur le substrat dans ladite chambre de dépôt, en présence des traces de fluor résiduel résultant dudit prétraitement.

Selon un mode de mise en oeuvre préféré du procédé conforme à la présente Invention, le prétraitement par le plasma fluoré de la chambre de dépôt est effectué pendant 5 à 120 secondes, à une pression comprise entre 6,65 et 1333 Pa (50 mTorrs et 10 Torrs), une puissance d'électrode comprise entre 30 et 600 Watts, un débit de gaz fluoré compris entre 10 et 200cm³/mn, et à une température identique à celle à laquelle sera effectué le futur dépôt de tungstène, à savoir entre 250°C et 500°C.

Selon une disposition préférée de ce mode de mise en oeuvre, le prétraitement par le plasma fluoré de la chambre de dépôt est effectué à une pression comprise entre 19,95 et 39,90 Pa (150 mTorrs et 1 Torr), et a une température comprise entre 3OO°C et 400°C.

Le procédé conforme à l'Invention peut être mis en oeuvre avec n'importe quel type de chambre de dépôt par C.V.D. ; dans le cas où l'on utilise une chambre de dépôt comportant un dispositif porte-substrat permettant de faire varier la distance entre le substrat et l'électrode génératrice de plasma, les meilleurs résultats sont obtenus en respectant une distance électrode/porte-substrat comprise entre 12,5 et 22 mm.

Pour la mise en oeuvre du procédé conforme à la présente Invention, le gaz fluoré utilisé est choisi dans le groupe constitué par le NF₃, le SF₆, le CF₄ et le HF. Le gaz diluant inerte peut être par exemple de l'hélium, de l'argon, ou de l'azote.

Le prétraitement de la chambre de dépôt effectué conformément à l'Invention permet en outre d'éliminer toute trace de gaz résiduels oxydants préalablement au dépôt du tungstène sélectif.

Le prétraitement par le fluor de la chambre de dépôt permet d'obtenir le dépôt de tungstène sélectif, à des températures élevées, sur les surfaces conductrices d'un substrat composé d'oxyde de silicium et de tungstène.

On peut procéder au prétraitement par le fluor de la chambre de dépôt préalablement à l'introduction du substrat ; on utilisera dans ce cas un dispositif permettant le transfert du substrat de la chambre de nettoyage à la chambre de dépôt sans exposition à l'action de gaz oxydants. De préférence, le substrat subira préalablement un prétraitement de nettoyage approprié à sa nature, par exemple par H2, SF6, BCl3, NF3, et/ou des gaz inertes, dans une atmosphère contrôlée, (par exemple sous vide, ou en présence d'hélium, d'argon, ou d'azote). On peut par exemple utiliser le dispositif et le prétraitement de nettoyage décrits dans la Demande de Brevet EP 0430 303 précitée.

Selon une variante très avantageuse, le substrat est introduit dans la chambre de dépôt préalablement à la mise en oeuvre du procédé de prétraitement de celle-ci conforme à l'invention. On effectue ainsi simultanément un prétraitement du substrat et le prétraitement de la chambre de dépôt : ceci permet en outre d'éviter tout contact du substrat avec l'air ou tout autre gaz oxydant consécutivement au traitement par le fluor.

Cette variante de l'Invention est particulièrement avantageuse dans le cas d'un substrat composé d'oxyde de silicium et de tungstène.

L'Inventeur a en effet découvert que contrairement à ce qui est suggéré par la publication de TAMARU et al. citée ci-dessus, un traitement fluoré d'un substrat oxyde de silicium/tungstène, permet d'améliorer considérablement la sélectivité du dépôt de tungstène effectué ultérieurement.

Il convient toutefois que le traitement fluoré du substrat soit effectué à doses appropriées ; si l'on considère un substrat dont la surface est formée de deux matériaux, à savoir l'oxyde de silicium et le tungstène (oxydé en surface) apparaissant au fond des trous gravés dans l'oxyde de silicium, la dose de fluor adéquate pour permettre ultérieurement un dépôt sélectif de tungstène, sera définie d'une part par le dosage minimum sur l'oxyde de silicium, et d'autre part par le dosage maximum sur le tungstène.

Ces doses peuvent être déterminées comme suit :
- Sur l'oxyde de silicium, le traitement doit être suffisant pour permettre le dépôt de quelques couches atomiques de fluor formant une barrière uniforme et imperméable qui bloque la nucléation du tungstène ; il n'y a pas de limite supérieure au nombre de couches de fluor déposées.
- En revanche, sur la partie du substrat constituée de tungstène oxydé, il n'y a pas de limite inférieure au dépôt de fluor, car le dépôt du tungstène par CVD peut être effectué même en l'absence de fluor. Une limite supérieure est atteinte lorsque la totalité de la couche d'oxyde de tungstène a été transformée en fluorure de tungstène. Tout apport supplémentaire de fluor attaque le tungstène et forme en surface une couche atomique de fluor qui empêche le dépôt ultérieur du tungstène par CVD.

La présente Invention a donc également pour objet un procédé de traitement d'un substrat constitué d'oxyde de silicium et de tungstène préalablement au dépôt sélectif de tungstène en phase vapeur, lequel procédé est mis en oeuvre dans une enceinte close, et en l'absence de toute trace de gaz oxydant pouvant interférer avec le dépôt de fluor sur le substrat, et est caractérisé en ce que l'on traite ledit substrat par un dérivé de fluor à une dose appropriée, ladite dose étant supérieure ou égale à la dose nécessaire pour permettre le dépôt d'au moins une couche atomique de fluor sur l'oxyde de silicium, et étant inférieure ou égale à la dose nécessaire pour assurer la transformation de la couche d'oxyde de tungstène en fluorure de tungstène.

Pour assurer l'absence de toute trace de gaz oxydant, le traitement fluoré du substrat, et si nécessaire, son transfert dans la chambre de dépôt sont effectués dans une atmosphère contrôlée, (par exemple sous vide, ou en présence d'hélium, d'argon, ou d'azote)

L'homme du métier peut déterminer aisément la dose de fluor appropriée pour un substrat oxyde de silicium/tungstène déterminé en procédant à quelques essais et en mesurant la quantité de fluor absorbé sur chacun des constituants du substrat. L'Inventeur a ainsi effectué des essais sur plusieurs types d'oxyde de silicium : le P.TEOS (Tétra Ethyle Ortho Silicate déposé par plasma), le USG (Undop Silicate Glass), le BSG (Boro Silicate Glass), le PSG (Phospho Silicate Glass), et le BPSG (Boro Phospho Silicate Glass). Parmi ces différents types d'oxyde, le P.TEOS exige une dose de fluor plus importante que les autres oxydes testés.

Selon un mode de mise en oeuvre préféré de la présente Invention, on procède au traitement fluoré du substrat dans une enceinte alimentée en NF₃, dans laquelle un plasma est généré par une électrode. Très avantageusement, cette enceinte alimentée en NF₃ n'est autre que la chambre de dépôt dans laquelle sera effectué ultérieurement le dépôt de tungstène sélectif. On procède de la sorte simultanément au prétraitement de la chambre de dépôt et au prétraitement du substrat.

La variation du temps de plasma permet de maintenir la dose de fluor constante à différentes températures de traitement ; à titre d'exemple, pour un substrat constitué en surface de P.TEOS et de tungstène, le temps de plasma varie de 5 secondes pour une température de traitement de 290°C, à 25 secondes pour une température de traitement de 400°C en vue de dépôts ultérieurs de tungstène sélectif aux mêmes températures.

Le procédé conforme à l'Invention peut être mis en oeuvre dans une chambre de dépôt comportant un dispositif porte-substrat permettant de faire varier la distance entre le substrat et l'électrode génératrice de plasma ; cette variation de distance permet également d'influer sur la dose de fluor.

La distance électrode-substrat varie par exemple entre 22 mm pour le dépôt de la dose de fluor minimum, et 12,5 mm pour le dépôt de la dose de fluor maximum.

Selon une disposition préférée de ce mode de mise en oeuvre, le traitement par le fluor est effectué pendant 5 à 25 secondes, à une pression comprise entre 19,95 et 39,90 Pa (150 et 300 mTorrs), une puissance d'électrode comprise entre 20 et 30 Watts, une température égale à celle à laquelle on procèdera ultérieurement au dépôt du tungstène (c'est à dire comprise entre 250 et 500°C, de préférence 300 à 400°C), un débit de NF₃ compris entre 25 et 30 cm³/mn, en présence de 50 cm³/mn d'argon, et de 50 cm³/mn de N₂, et une distance électrode-substrat comprise entre 12,5 et 22mm.

Bien qu'il soit particulièrement avantageux de procéder au prétraitement fluoré du substrat composé d'oxyde de silicium et de tungstène dans l'enceinte qui servira ultérieurement au dépôt du tungstène sélectif, ledit substrat peut également être prétraité séparément et ensuite transféré dans la chambre de dépôt, elle-même prétraitée ou non.

Selon un mode de mise en oeuvre préféré de la présente Invention, on procède au traitement fluoré du substrat dans une enceinte de gravure conventionnelle de type RIE, par un plasma de NF₃. Dans ce mode de mise en oeuvre, à conditions de pression, température, débit de NF₃ et puissance de l'électrode RF déterminées, on obtient le dosage de fluor désiré en faisant varier le temps d'exposition du substrat dans le plasma ; ce dosage peut en effet varier selon le traitement qu'a subi l'oxyde auparavant, ou de par sa nature.

Selon une disposition préférée de ce mode de mise en oeuvre, le traitement par le fluor est effectué à une pression comprise entre 26,66 et 66,66 Pa (200 et 500 mTorrs), une puissance d'électrode comprise entre 20 et 30 Watts, une température comprise entre 15 et 50°C, un débit de NF₃ compris entre 15 et 40 cm³/mn, un débit d'hélium compris entre 40 et 100 cm³/mn.

A titre d'exemple, pour un substrat constitué en surface de P.TEOS et de tungstène, à une pression de 39,90 Pa (300mTorr), une puissance d'électrode de 30 Watts, un débit de NF₃ de 20 cm³/mn, et un débit d'hélium de 50 cm³/mn, le temps de plasma varie entre 15 secondes pour le dépôt de la dose de fluor minimum, et 150 secondes pour le dépôt de la dose de fluor maximum.

Selon encore un autre mode de mise en oeuvre préféré de la présente Invention, on procède au traitement à chaud du substrat, sous balayage de fluorure de xénon. On contrôle la quantité de fluor déposé en faisant varier le temps d'exposition au XeF₂ et/ou la température de traitement.

Après traitement selon l'un ou l'autre des deux modes de mise en oeuvre énoncés ci-dessus, le substrat est transféré dans la chambre de dépôt sous atmosphère contrôlée, afin d'éviter toute oxydation.

L'on peut procéder au dépôt sélectif de tungstène en phase vapeur dans la chambre de dépôt et/ou sur le substrat ayant subi un prétraitement conforme à l'invention, selon n'importe quel des protocoles classiques de dépôt de tungstène en phase vapeur (WF₆/SiH₄) connus en eux-mêmes de l'homme du métier ; le prétraitement conforme à l'Invention permet toutefois d'utiliser des températures beaucoup plus élevées que celles préconisées dans l'art antérieur pour un dépôt sélectif. L'Inventeur a procédé à différentes expérimentations de dépôt sélectif de tungstène d'épaisseur supérieure au micron, en opérant à des températures de 300°C à 400°C. Dans tous les cas il a obtenu un dépôt sélectif de tungstène qui, tout en conservant une sélectivité parfaite, présentait tous les avantages apportées par le dépôt à ces températures élevées, à savoir une amélioration de la contrainte et de l'adhérence du matériau déposé, et une réduction de la résistance d'interconnexion.

De par ces caractéristiques, le dépôt de tungstène sélectif effectué conformément à l'Invention peut être utilisé dans la fabrication des circuits intégrés, en permettant des connexions inter-couches métalliques d'un diamètre inférieur à 0,3 microns, tout en simplifiant leur production.

La présente Invention sera mieux comprise à l'aide du complément de description qui va suivre, qui se réfère à des exemples de mise en oeuvre du procédé conforme à l'Invention.

Il va de soi toutefois que ces exemples sont donnés uniquement à titre d'illustration de l'objet de l'Invention dont ils ne constituent en aucune manière une limitation.

### EXEMPLE 1. - EFFET DU PRETRAITEMENT PAR LE FLUOR DE LA CHAMBRE DE DEPOT SUR LES CARACTERISTIQUES DU DEPOT DE TUNGSTENE SELECTIF.

Cette expérimentation a été effectuée dans une chambre de dépôt APPLIED MATERIALS du type de celle décrite dans la Demande EP 0430 303.

Afin de déterminer la dose de fluor optimale à faire absorber par les éléments constituant la chambre de dépôt, 5 points de fonctionnement liés à la variation des paramètres de prétraitement ont été définis comme suit :
- Prétraitement n° 1 : pas de prétraitement ;
- Prétraitement n° 2 : Temps = 10 sec ; NF3 = 30 cm³ dilué dans Ar = N2 = 50 cm³ ; Pression = 39,90 Pa (300mTorr) ; Puissance de l'électrode = 30 Watts.
- Prétraitement n 3 : Temps = 10 sec. ; NF3 = 150 cm³ pur ; Pression = 39,90 Pa (300mTorr) Puissance de l'électrode = 70 Watts.
- Prétraitement n° 4 : Temps = 30 sec. ; NF3 = 150 cm³ pur ; Pression = 39,90 Pa (300mTorr) ; Puissance de l'électrode = 150 Watts.
- Prétraitement n°5 : Temps = 60 sec. ; NF3 = 1500 cm³ pur ; Pression = 39,90 Pa (300mTorr) ; Puissance de l'électrode = 300 Watts.
- Prétraitement n°6 : Temps = 120 sec. ; NF3 = 150 cm³ pur ; Pression = 39,90 Pa (300mTorr) ; Puissance de l'électrode = 300 Watts.

Après prétraitement, le substrat est placé dans l'enceinte de dépôt, et l'on procède au dépôt du tungstène à différentes températures, les autres paramètres du dépôt étant identiques à ceux décrits dans la Demande EP 0430 303.

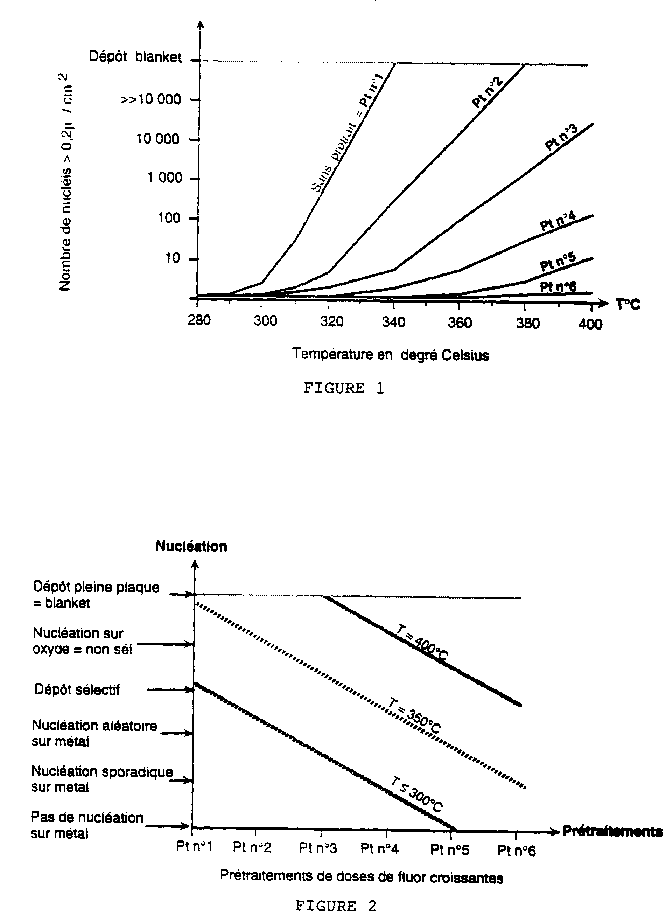

Pour apprécier l'efficacité de ces prétraitements, les 2 méthodes suivantes ont été utilisées ; les résultats correspondants sont illustrés par les Figures 1 et 2 :
A) - La Figure 1 représente le nombre de nucléis sur SiO2 (image de la perte de sélectivité) en fonction de la température de dépôt, pour les différents prétraitements de la chambre de dépôt représentant le dosage du fluor absorbé par les éléments de la chambre de dépôt.
   La sélectivité est appréciée par le comptage de particules de tungstène sur des substrats comprenant en surface uniquement de l'oxyde de silicium, effectué après prétraitement de l'enceinte de dépot et dépôt de tungstène.
   A titre de témoin, on utilise un substrat qui a été traité dans les conditions du dépôt de tungstène définies ci-dessus, mais en l'abscence de WF₆ ; connaissant le nombre de particules sur ce substrat témoin, on en déduit le nombre de nucléis de tungstène effectivement déposés pour chaque expérimentation, ce qui permet d'apprécier la sélectivité. L'échelle, reportée sur la Figure 1, est graduée en nombre de particules par cm²: pour un nombre inférieur à 10 particules/cm2 le dépôt est dit "sélectif" et pour un nombre supérieur à 10 000 particules/cm² le dépôt est dit "pleine plaque".
B) - La Figure 2 représente la qualité de nucléation du dépôt en fonction de la dose de fluor induite dans la chambre de dépôt, à différentes T°C de dépôt.

La nucléation est appréciée par l'observation au microscope électronique à balayage, (MEB) du dépôt de tungstène sélectif sur un substrat qui est formé dans ce cas de batteries de trous de différents diamètres laissant apparaître une surface métallique (tungstène) au travers de l'oxyde de silicium.

L'échelle, reportée sur la Figure 2, est définie par les points suivants :
1) Pas de dépôt de tungstène sur le matériau support métallique = "pas de nucléation".
2) Dépôt de tungstène non-continu sur les grandes surfaces du matériau support métallique = "nucléation sporadique"
3) Dépôt de tungstène aléatoire dans les surfaces de faibles diamètres du matériau support métallique = "mauvaise nucléation".
4) Dépôt de tungstène remplissant correctement toutes les surfaces de différents diamètres du matériau support métallique = "sélectif".
5) Dépôt de tungstène nucléant sur l'oxyde de silicium = "non sélectif".

### EXEMPLE 2. - PRETRAITEMENT D'UN SUBSTRAT OXYDE DE SILICIUM/TUNGSTENE : DETERMINATION DE LA QUANTITE DE FLUOR DEPOSEE

Le substrat est déposé dans une enceinte de gravure de type RIE ALCATEL (type GIR) sur l'électrode RF.

Les conditions expérimentales sont les suivantes :
. Pression : 39,90 Pa (300mTorr)
. Puissance du plasma : 30 Watts
. Température : 40°C
. Débit de NF₃ : 20 cm³/mn
   (dilué dans 50 cm³/mn d'He).

Dans ces conditions le dosage minimum est assuré par un temps d'exposition de 15 secondes de substrat au plasma de NF₃ et le dosage maximum par un temps d'exposition de 150 secondes.

La quantité de fluor absorbé est évaluée par analyse AES qui mesure la vitesse de désorption.

Cette analyse est effectuée dans les conditions suivantes :
- Irradiation : 6 µA,
- Energie e- : 3 KeV

Le faisceau d'électrons balaye un carré de 200 µ de côté.

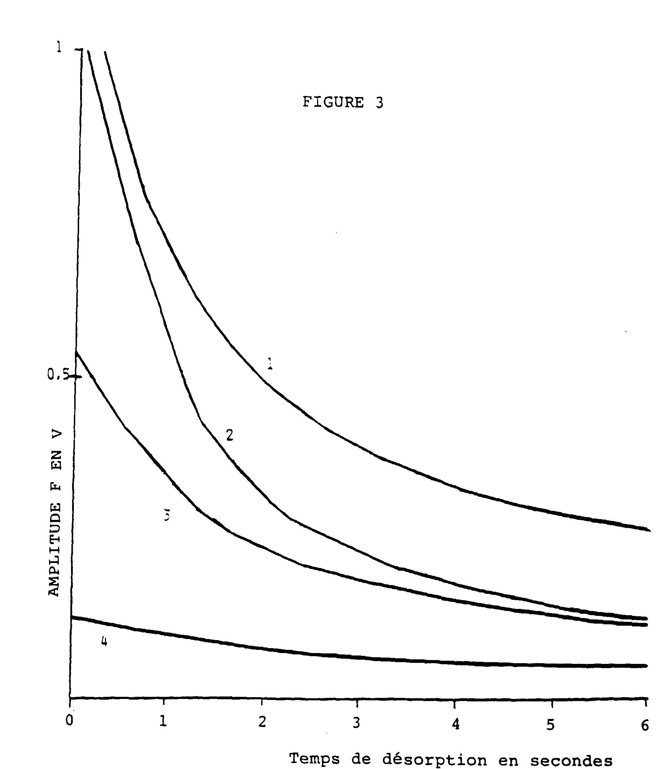

Les résultats sont illustrés dans la Figure 3 :
Courbe 1 : Substrat = SiO2
Durée du traitement fluoré : 150 sec.
Courbe 2 : Substrat = tungstène
Durée du traitement fluoré : 15 sec.
Courbe 3 : Substrat = tungstène SiO₂
Durée du traitement fluoré : 150 sec.
Courbe 4 : Substrat = tungstène
Durée du traitement fluoré : 15 sec..

Ces courbes indiquent que le fluor désorbe plus lentement sur les échantillons 1 et 3 que sur les échantillons 2 et 4, montrant que la dose de fluor absorbée est plus importante pour un traitement de 150 secondes que pour un traitement de 15 secondes. Il est ainsi possible pour un matériau support donné, d'obtenir une évaluation de la dose de fluor absorbée en fonction des différents paramêtres de traitement, et ensuite d'ajuster ces paramètres afin de déposer la dose de fluor nécessaire selon la température à laquelle on souhaite effectuer le dépôt de tungstène sélectif.

### EXEMPLE 3. - EFFET DU PRETRAITEMENT PAR LE FLUOR DU SUBSTRAT ET DE LA CHAMBRE DE DEPOT SUR LES CARACTERISTIQUES DU DEPOT DE TUNGSTENE.

Le prétraitement au fluor s'effectue sur le substrat placé à l'intérieur de la chambre de dépôt.
- Prétraitement fluoré de l'enceinte de dépôt par un plasma de NF3, le plasma étant généré par une électrode et le porte-substrat étant indépendant de ladite électrode.
- Les conditions du prétraitement sont celles décrites à l'exemple 1, pour le Prétraitement n°2, à savoir : Temps = 10 sec. ; NF3 = 30 cm³ dilué dans Ar = N2 = 50cm³; Pression = 39,90 Pa (300mTorr) ; Puissance de l'électrode = 30 Watts ; Espace porte-substrat/électrode = 22 mm.

La variation du temps de plasma permet de maintenir la dose de fluor constante, à différentes températures de prétraitement et dépôt ; à titre d'exemple, pour un substrat constitué en surface de P.TEOS et de tungstène, le temps de plasma varie de 5s pour T = 290°C à 25 sec. pour T = 400°C.

La qualité de la nucléation observée au MEB, (méthode B) décrite à l'exemple 1), est pratiquement constante et oscille autour du point défini "dépôt sélectif".

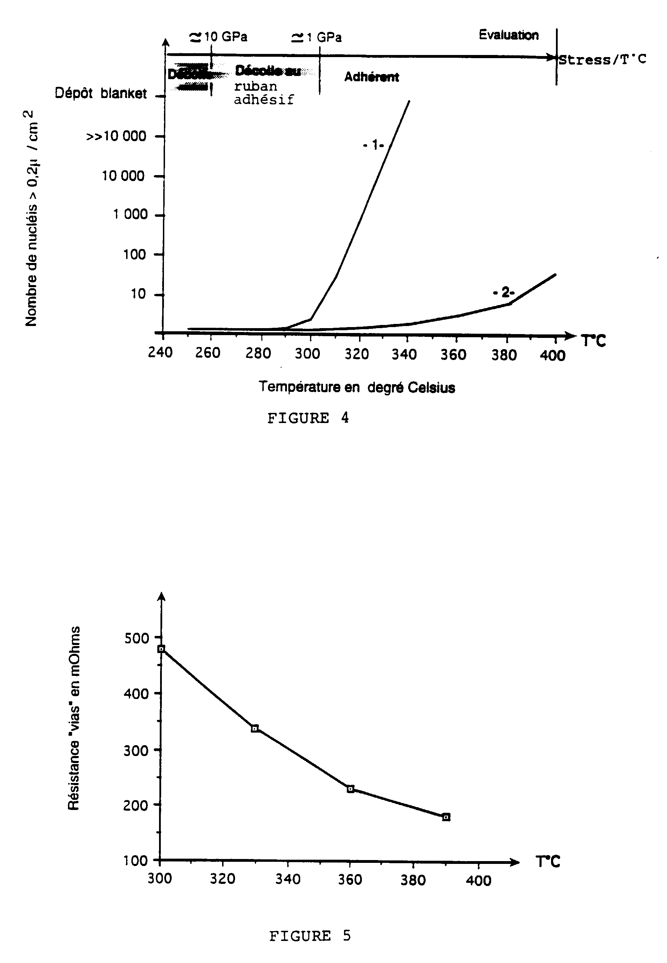

- La Figure 4 représente, à mêmes conditions de dépôt du tungstène sélectif (décrites à l'Exemple 1), la contrainte et la sélectivité en fonction de la température.

L'axe supérieur de la Figure 4 représente l'évaluation de la contrainte et de la résistance du matériau de tungstène sélectif pour des épaisseurs de dépôt de 7000Å, en fonction de la température de dépôt.

Pour des températures inférieures à 300°C, les contraintes sont supérieures à 1 GPa et la couche de tungstène déposée se décolle très facilement du substrat (arrachement par un ruban adhésif), et pour des températures de dépôt supérieures à 300°C, le dépôt n'est plus sélectif.

La Figure 4 représente également la perte de sélectivité en fonction de la température (méthode de mesure A) décrite à l'exemple 1) pour un substrat constitué en surface de P.TEOS et de tungstène : la courbe (1) pour des substrats et une chambre n'ayant pas subi de prétraitement au fluor, et la courbe (2) pour des substrats et une chambre ayant subi le prétraitement conforme à l'Invention, ce qui illustre l'efficacité dudit prétraitement.

D'autre part, la courbe de la Figure 5 représente la résistance moyenne des "via" (jonctions entre couches assurées par les trous remplis de tungstène) de diamètre 1 µm mesurée sur circuit, en fonction de la température du dépôt de tungstène sélectif.

La résistance moyenne est composée de l'addition des résistances d'interfaces entre le tungstène sélectif et les couches métalliques, (tungstène pleine plaque en couche inférieure et Al/Si en couche supérieure dans cet exemple), et de la résistance du tungstène sélectif qui dépend de la résistivité du tungstène sélectif et des dimensions du via (diamètre = 1 µm et épaisseur de remplissage = 7000Å.

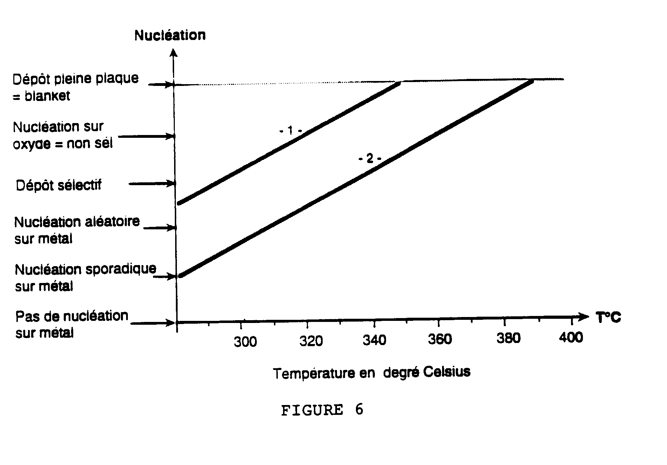

La Figure 6 représente la nucléation du dépôt de tungstène sélectif sur un substrat prétraité comme décrit à l'Exemple 2, et transféré, sous atmosphère contrôlée afin d'éviter toute oxydation, dans une chambre de dépôt non prétraitée. La courbe 1 correspond à un prétraitement du substrat à la dose de fluor minimum, et la courbe 2 à un prétraitement du substrat à la dose de fluor maximum.

Ainsi que cela ressort de ce qui précède, l'Invention ne se limite nullement à ceux de ses modes de mise en oeuvre, de réalisation et d'application qui viennent d'être décrits de façon plus explicite ; elle en embrasse au contraire toutes les variantes qui peuvent venir à l'esprit du technicien en la matière, sans s'écarter du cadre, ni de la portée de la présente Invention.

## Revendications

1. Procédé de dépôt sélectif de tungstène sur un substrat constitué de tungstène et d'oxyde de silicium, dans lequel l'on effectue un prétraitement par le fluor de la chambre de dépôt en induisant dans ladite chambre de dépôt un plasma de gaz fluoré, optionnellement associé à un gaz diluant inerte, caractérisé en ce que l'on effectue le dépôt de tungstène en phase vapeur sur le substrat dans ladite chambre de dépôt, en présence des traces de fluor résiduel résultant dudit prétraitement.

2. Procédé selon la revendication 1, caractérisé en ce que le prétraitement de la chambre de dépôt est effectué pendant 5 à 120 secondes, à une pression comprise entre 6,65 et 1333 Pa (50 mTorrs et 10 Torrs), une puissance d'électrode comprise entre 30 et 600 Watts, un débit de gaz fluoré compris entre 10 et 200cm³/mn, et à une température comprise entre 250°C et 500°C.

3. Procédé selon la revendication 2, caractérisé en ce que le prétraitement par le fluor de la chambre de dépôt est effectué pendant 5 à 120 secondes, à une pression comprise entre 19,95 et 133,3 Pa (150 mTorrs et 1 Torr), et à une température comprise entre 300°C et 400°C.

4. Procédé selon l'une quelconque des revendications 1 à 3, caractérisé en ce que le gaz fluoré utilisé est choisi dans le groupe constitué par le NF₃, le SF₆, le CF₄ et le HF.

5. Procédé selon l'une quelconque des revendications 1 à 4, caractérisé en ce que l'on procéde au prétraitement par le fluor de la chambre de dépôt préalablement à l'introduction du substrat.

6. Procédé selon l'une quelconque des revendications 1 à 4, caractérisé en ce que l'on procéde au prétraitement par le fluor après l'introduction du substrat dans la chambre de dépot.

7. Procédé de dépôt sélectif de tungstène sur un substrat constitué d'oxyde de silicium et de tungstène, caractérisé en ce que l'on effectue un prétraitement dudit substrat, dans une enceinte close et en l'absence de toute trace de gaz oxydant, par un dérivé de fluor à une dose supérieure ou égale à la dose nécessaire pour permettre le dépôt d'au moins une couche atomique de fluor sur l'oxyde de silicium, et inférieure ou égale à la dose nécessaire pour assurer la transformation de la couche d'oxyde de tungstène en fluorure de tungstène, et en ce que l'on effectue le dépôt en phase vapeur de tungstène sur le substrat, en présence du fluor déposé par ledit prétraitement.

8. Procédé selon une quelconque des Revendications 1 ou 7, caractérisé en ce que l'on procède au traitement fluoré du substrat dans une enceinte alimentée en NF₃, le plasma étant généré par une électrode, et le substrat étant indépendant de ladite électrode.

9. Procédé selon la Revendication 8, caractérisé en ce que le traitement par le fluor est effectué pendant 5 à 25 secondes, à une pression comprise entre 19,95 et 39,90 Pa (150 et 300 mTorrs), une puissance d'électrode comprise entre 20 et 30 Watts, une température comprise entre 250 et 400°C, un débit de NF₃ compris entre 25 et 30 cm³/mn, en présence de 50 cm³/mn d'argon, et de 50 cm³/mn de N₂.

10. Procédé selon une quelconque des revendications 1 ou 7, caractérisé en ce que l'on procède au traitement fluoré du substrat dans une enceinte de gravure conventionnelle de type RIE, par un plasma de NF₃.

11. Procédé selon la Revendication 10, caractérisé en ce que le traitement par le fluor est effectué à une pression comprise entre 26,66 et 66,66 Pa (200 et 500 mTorrs), une puissance d'électrode comprise entre 20 et 30 Watts, une température comprise entre 15 et 50°C, un débit de NF₃ compris entre 15 et 40 cm³/mn, un débit d'hélium compris entre 40 et 100 cm³/mn.

12. Procédé selon la Revendication 1, caractérisé en ce que le traitement fluoré est effectué par traitement à chaud du substrat, sous balayage de fluorure de xénon.

13. Procédé selon une quelconque des revendications 1 à 12, caractérisé en ce que l'on effectue le dépôt en phase vapeur du tungstène à une température comprise entre 250°C et 500°C.

14. Procédé selon la revendication 13 caractérisé en ce que l'on effectue le dépôt en phase vapeur de tungstène à une température comprise entre 300° et 400°C

## Patentansprüche

1. Verfahren zur selektiven Abscheidung von Wolfram auf ein Substrat, bestehend aus Wolfram und Siliciumoxid, bei dem man eine Vorbehandlung der Abscheidungskammer mit Fluor vornimmt, indem man in diese Abscheidungskammer ein Plasma eines fluorhaltigen Gases, ggf. kombiniert mit einem inerten Verdünnungsgas, einführt, dadurch **gekennzeichnet**, daß man die Abscheidung von Wolfram in Dampfphase auf das Substrat in der Abscheidungskammer in Gegenwart von Spuren von restlichem Fluor, die aus der Vorbehandlung stammen, durchführt.

2. Verfahren nach Anspruch 1, dadurch **gekennzeichnet**, daß die Vorbehandlung der Abscheidungskammer während 5 bis 120 Sekunden bei einem Druck im Bereich von 6,65 bis 1.333 Pa (50 mTorr und 10 Torr), einer Elektrodenleistung im Bereich von 30-600 Watt, einem Durchsatz an fluorhaltigem Gas im Bereich von 10 bis 200 cm³/min und bei einer Temperatur im Bereich von 250°C bis 500°C vorgenommen wird.

3. Verfahren nach Anspruch 2, dadurch **gekennzeichnet**, daß die Vorbehandlung der Abscheidungskammer mit Fluor während 5 bis 120 Sekunden bei einem Druck im Bereich von 19,95 und 133,3 Pa (150 mTorr und 1 Torr) und bei einer Temperatur im Bereich von 300°C bis 400°C vorgenommen wird.

4. Verfahren nach einem der Ansprüche 1 bis 3, dadurch **gekennzeichnet**, daß das eingesetzte fluorhaltige Gas aus der Gruppe bestehend aus NF₃, SF₆, CF₄ und HF ausgewählt wird.

5. Verfahren nach einem der Ansprüche 1 bis 4, dadurch **gekennzeichnet**, daß man die Vorbehandlung der Abscheidungskammer mit Fluor vor dem Einbringen des Substrates vornimmt.

6. Verfahren nach einem der Ansprüche 1 bis 4, dadurch **gekennzeichnet,** daß man die Vorbehandlung mit Fluor nach dem Einbringen des Substrates in die Abscheidungskammer vornimmt.

7. Verfahren zum selektiven Abscheiden von Wolfram auf ein Substrat, bestehend aus Siliciumoxid und Wolfram, dadurch **gekennzeichnet**, daß man eine Vorbehandlung des Substrats in einem geschlossenen Raum und in Abwesenheit irgendwelcher Spuren von oxidierendem Gas mit einer Fluorverbindung in einer Dosis vornimmt, die höher oder gleich ist der notwendigen Dosis, um die Abscheidung mindestens einer atomaren Fluorschicht auf dem Siliciumoxid zu erhalten, und die kleiner oder gleich ist der notwendigen Dosis, um die Umwandlung der Wolframoxidschicht in Wolframfluorid sicherzustellen, und daß man die Abscheidung von Wolfram auf das Substrat in Dampfphase in Gegenwart des durch die Vorbehandlung abgeschiedenen Fluors vornimmt.

8. Verfahren nach einem der Ansprüche 1 oder 7, dadurch **gekennzeichnet**, daß man die Fluorbehandlung des Substrats in einem mit NF₃ gespeisten Raum vornimmt, wobei das Plasma von einer Elektrode erzeugt wird und das Substrat von der Elektrode unabhängig ist.

9. Verfahren nach Anspruch 8, dadurch **gekennzeichnet**, daß die Fluorbehandlung während 5 bis 25 Sekunden bei einem Druck im Bereich von 19,95 und 39,90 Pa (150 und 300 mTorr), einer Elektrodenleistung im Bereich von 20 bis 30 Watt, einer Temperatur im Bereich von 250 und 400°C, einem Durchsatz an NF₃ im Bereich von 25 bis 30 cm³/min, in Gegenwart von 50 cm³/min Argon und von 50 cm³/min N₂ durchgeführt wird.

10. Verfahren nach einem der Ansprüche 1 oder 7, dadurch **gekennzeichnet**, daß man die Fluorbehandlung des Substrats in einer gebräuchlichen Gravurkammer des Typs RIE mit einem NF₃-Plasma durchführt.

11. Verfahren nach Anspruch 10, dadurch **gekennzeichnet**, daß die Fluorbehandlung bei einem Druck im Bereich von 26,66 und 66,66 Pa (200 und 500 mTorr), einer Elektrodenleistung im Bereich von 20 bis 30 Watt, einer Temperatur im Bereich von 15 bis 50°C, bei einem Durchsatz an NF₃ im Bereich von 15 bis 40 cm³/min und bei einem Durchsatz an Helium im Bereich von 40 bis 100 cm³/min durchgeführt wird.

12. Verfahren nach Anspruch 1, dadurch **gekennzeichnet**, daß die Fluorbehandlung durch Behandlung des Substrats in der Wärme unter Spülen mit Xenonfluorid durchgeführt wird.

13. Verfahren nach einem der Ansprüche 1 bis 12, dadurch **gekennzeichnet**, daß man die Dampfphasen-Abscheidung von Wolfram bei einer Temperatur im Bereich von 250°C bis 500°C vornimmt.

14. Verfahren nach Anspruch 13, dadurch **gekennzeichnet,** daß man die Dampfphasen-Abscheidung von Wolfram bei einer Temperatur im Bereich von 300-400°C vornimmt.

## Claims

1. Process for the selective deposition of tungsten on a substrate consisting of tungsten and of silicon oxide, in which a pretreatment of the deposition chamber is carried out with fluorine by inducing a plasma of fluorine-containing gas, optionally combined with an inert diluting gas, in the said deposition chamber, characterized in that the chemical vapour deposition of tungsten on the substrate is carried out, in the said deposition chamber, in the presence of the traces of residual fluorine resulting from the said pretreatment.

2. Process according to Claim 1, characterized in that the deposition chamber is pretreated for 5 to 120 seconds at a pressure between 6.65 and 1333 Pa (50 millitorr and 10 torr), an electrode power between 30 and 600 watts, a flow rate of fluorine-containing gas between 10 and 200 cm³/min and at a temperature between 250°C and 500°C.

3. Process according to Claim 2, characterized in that the deposition chamber is pretreated for 5 to 120 seconds with fluorine at a pressure between 19.95 and 133.3 Pa (150 millitorr and 1 torr) and a temperature between 300°C and 400°C.

4. Process according to any one of Claims 1 to 3, characterized in that the fluorine-containing gas used is chosen from the group formed by NF₃, SF₆, CF₄ and HF.

5. Process according to any one of Claims 1 to 4, characterized in that the fluorine pretreatment of the deposition chamber is carried out prior to the introduction of the substrate.

6. Process according to any one of Claims 1 to 4, characterized in that the fluorine pretreatment is carried out after the introduction of the substrate into the deposition chamber.

7. Process for the selective deposition of tungsten on a substrate consisting of silicon oxide and of tungsten, characterized in that a pretreatment of the said substrate is carried out, in a closed chamber and in the absence of any trace of oxidizing gas, with a fluorine derivative at a dose greater than or equal to the dose necessary to allow deposition of at least one atomic layer of fluorine on the silicon oxide, and less than or equal to the dose necessary to ensure conversion of the tungsten oxide layer into tungsten fluoride, and in that the chemical vapour deposition of tungsten on the substrate is carried out in the presence of the fluorine deposited by the said pretreatment.

8. Process according to either of Claims 1 and 7, characterized in that the fluorine treatment of the substrate is carried out in a chamber supplied with NF₃, the plasma being generated by an electrode and the substrate being independent of the said electrode.

9. Process according to Claim 8, characterized in that the fluorine treatment is performed for 5 to 25 seconds at a pressure between 19.95 and 39.90 Pa (150 and 300 millitorr), an electrode power between 20 and 30 watts, a temperature between 250 and 400°C, a NF₃ flow rate between 25 and 30cm³/min in the presence of 50 cm³/min of argon and of 50 cm³/min of N₂.

10. Process according to either of Claims 1 and 7, characterized in that the fluorine treatment of the substrate is carried out in a conventional etching chamber of the RIE type by an NF₃ plasma.

11. Process according to Claim 10, characterized in that the fluorine treatment is performed at a pressure between 26.66 and 66.66 Pa (200 and 500 millitorr), an electrode power between 20 and 30 watts, a temperature between 15 and 50°C, an NF₃ flow rate between 15 and 40 cm³/min and a helium flow rate between 40 and 100 cm³/min.

12. Process according to Claim 1, characterized in that the fluorine treatment is performed by hot treatment of the substrate under a sweep of xenon fluoride.

13. Process according to any one of Claims 1 to 12, characterized in that the chemical vapour deposition of tungsten is carried out at a temperature between 250°C and 500°C.

14. Process according to Claim 13, characterized in that the chemical - vapour deposition of tungsten is carried out at a temperature between 300° and 400°C.
